(19) **Europäisches Patentamt**
**European Patent Office**
**Office européen des brevets**

(11) **EP 2 577 743 B1**

(12) **EUROPEAN PATENT SPECIFICATION**

(45) Date of publication and mention
of the grant of the patent:
**13.01.2016 Bulletin 2016/02**

(21) Application number: **11727295.5**

(22) Date of filing: **23.05.2011**

(51) Int Cl.:
*H01L 31/055* (2014.01)     *H01L 31/054* (2014.01)

(86) International application number:
**PCT/IB2011/052235**

(87) International publication number:
**WO 2011/148307 (01.12.2011 Gazette 2011/48)**

(54) **LUMINESCENT SOLAR CONCENTRATOR SYSTEM**

LUMINESZENTES SONNENKONZENTRATORSYSTEM

SYSTÈME DE CONCENTRATEUR SOLAIRE LUMINESCENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.05.2010 EP 10163760**

(43) Date of publication of application:
**10.04.2013 Bulletin 2013/15**

(73) Proprietor: **Koninklijke Philips N.V.
5656 AE Eindhoven (NL)**

(72) Inventors:
• **CORNELISSEN, Hugo Johan
NL-5656 AE Eindhoven (NL)**

• **DE ZWART, Siebe Tjerk
NL-5656 AE Eindhoven (NL)**

(74) Representative: **van Eeuwijk, Alexander Henricus
Waltherus
Philips Intellectual Property & Standards
High Tech Campus 5
5656 AE Eindhoven (NL)**

(56) References cited:
**US-A- 4 110 123       US-A1- 2009 126 778
US-A1- 2009 151 786**

**Description**

FIELD OF THE INVENTION

The invention relates to a Luminescent Solar Concentrator system comprising a converter component with a luminescent material for spectrally converting incident light, particularly sunlight. Moreover, it relates to a method for collecting and concentrating external light, particularly sunlight, with the help of a luminescent converter component.

BACKGROUND OF THE INVENTION

The WO 2009/067479 A2 discloses a Luminescent Solar Concentrator (in the following abbreviated "LSC") with a modular design. The LSC comprises waveguide-tiles with a particular curved, convex shape comprising a luminescent material, for example fluorescent dyes, for absorbing incident sunlight and reemitting it at longer wavelengths. Photocells arranged at the perimeter of the tiles convert the light they receive from the waveguide into electrical energy. The waveguide-tiles have side lengths between 50 mm and 250 mm, preferably between 130 mm and 160 mm, while their thickness is preferably about 3 mm.

The US 2009/0126778 A1 discloses a luminescent solar concentrator with a plurality of waveguides covering an area and collecting solar light at photovoltaic cells disposed at the perimeters of the waveguides.

The US 4,110,123 discloses an apparatus comprising a thin plastic plate with fluorescent centers at which sunlight is converted into fluorescence light. The fluorescence light is extracted from the plate and led to solar cells at reflectively coated notches, wherein the distance between these notches is kept below the absorption length.

SUMMARY OF THE INVENTION

Based on this background it was an object of the present invention to provide means for an efficient and cost-effective collection of light energy, particularly for the conversion of a sunlight into electrical energy.

This object is achieved by a Luminescent Solar Concentrator (LSC) system according to claim 1 and a method according to claim 2. Preferred embodiments are disclosed in the dependent claims.

The Luminescent Solar Concentrator system (or short LSC system) according to the present invention is intended for collecting external light, particularly sunlight. In many cases the collected light will be converted into electrical energy, though other applications of the collected light are possible, too. The LSC system comprises the following principal components:

a) A light guiding component that comprises a luminescent material for converting incident external light into light of longer wavelengths. This light guiding component will in the following be called "luminescent converter component" or simply "converter component". The converter component shall further have opposite surfaces defining a thickness D of the converter component. One of these surfaces will be called "outer surface" in the following because it shall be a surface through which external light can enter the converter component. The other surface will accordingly be called "inner surface". In many applications, the outer surface and the inner surface will be substantially parallel to each other. If they are not parallel, the thickness D will be defined as the mean distance between these two surfaces.

Moreover, the material of the converter component has an absorption coefficient $a_x$ for incident sunlight, and a (re-)absorption coefficient $a_c$ for the converted light ("luminescence light") that is emitted by its luminescent material. The ratio $R = a_x/a_c$ between the absorption and the reabsorption coefficient is then a parameter characterizing the converter component, wherein high values of R (e.g. $\geq$ 10000) are desirable for reasons of conversion efficiency.

b) A plurality of light extraction components for extracting light from the aforementioned luminescent converter component through its inner surface, wherein said light extraction components are located at extraction sites having mean distances W from each other that are smaller or equal than about (R/10.0) times the thickness D of the luminescent converter component, i.e. $W \leq 0.1 \cdot RD$. The light that is extracted from the luminescent converter component will usually comprise luminescence light originating from the conversion of external light as well as direct external light.

It should be noted that, in the context of the present invention, an "absorption coefficient a" is as usually defined as the constant characterizing the exponential decrease of light intensity I(z) after traveling a distance z through a considered material according to the formula $I(z) = I_0 \cdot \exp(-az)$. A possible wavelength-dependence of the coefficient a is eliminated in this formula by an integration over the complete spectrum of the light considered, i.e. of the (standard) sunlight in case of $a_x$ and of the resulting luminescence light in case of $a_c$. In the case of the converter component, the reabsorption coefficient $a_c$ may also take scattering losses into account.

The described Luminescent Solar Concentrator system achieves a high efficiency because light is extracted from the luminescent converter component at a plurality of extraction sites, the sites being spaced apart from each other not too far with respect to the thickness of the converter component in view of its absorption/reabsorption characteristics. By this geometrical design restriction, losses within the converter component due to scattering and reabsorption of photons can be limited.

The invention further relates to a method for collecting and concentrating external light, particularly sunlight, said method comprising the following steps:

a) Collecting external light by a luminescent converter component which has a thickness D between an outer surface and an opposite inner surface and a ratio R between the absorption coefficient $a_x$ for sunlight and the reabsorption coefficient $a_c$ for luminescence light.

b) Extracting light from the aforementioned luminescent converter component through its inner surface at extraction sites having mean distances $W \leq 0.1 \cdot RD$ from each other.

The method comprises in general form the steps that can be executed with the LSC system defined above. Reference is therefore made to the above description for more information on the details and advantages of the method.

In the following, various preferred embodiments will be described that relate both to the LSC system and the method defined above.

In a first particular embodiment, the value of the distance W between the light extraction sites is further restricted to the range $W \leq 0.05 \cdot RD$, preferably to the range between about $0.02 \cdot RD$ and $0.05 \cdot RD$.

The thickness D of the luminescent converter component may preferably range between 10 mm and 0.1 mm, most preferably between 3 mm and 0.1 mm. These values are favorable because they allow to construct an LSC system of low weight. The small values become possible without losses in collection efficiency because light is extracted from the thin luminescent converter component at a plurality of extraction sites not farther apart from each other than $0.1 \cdot RD$.

There are several ways how light can be extracted from the luminescent converter component at the extraction sites. According to a first realization, at least one of the light extraction components comprises a surface of the luminescent converter component that is mirroring (i.e. reflective). When light propagating within the converter component hits the mirroring surface, it will be deflected from its normal path and hence assume a state (angle of incidence) allowing it to leave the converter component.

The aforementioned mirroring surface may preferably be slanted with respect to the inner surface of the luminescent converter component, particularly be slanted at an acute angle. Light reflected by the mirroring surface will hence in the majority of cases reach the inner surface at an angle allowing a passage through said surface without total internal reflection.

In a preferred embodiment of the mirroring surface, the reflectivity of this surface is wavelength-selective. The reflectivity for luminescence light generated in the converter component may particularly be higher than the reflectivity for unconverted (external) light. In this way primarily converted light is extracted from the luminescent converter component, while unconverted light remains in the element, increasing its chance to be converted later.

According to another realization, at least one light extraction component may comprise a transparent optical element that contacts the inner surface of the luminescent converter component at an extraction site. In this embodiment the reflective indices of the converter component and said transparent optical element preferably match each other such that light hitting the inner surface from within the converter component may readily pass into the transparent optical element without significant reflection or refraction. Once within the transparent optical element, the extracted light may be guided to some desired destination with the help of known principles like reflection, refraction, or diffraction.

As was already mentioned, an important application of the LSC system will be the conversion of external (sun-)light into electricity. To this end, the LSC system may preferably comprise at least one solar cell, i.e. a photo element which can converter (visible, UV and/or IR) light into electrical energy. Suitable solar cells for this purpose are known to a person skilled in the art (cf. WO 2009/067479 A2).

The mentioned solar cell may in a particular embodiment of the invention be located at an extraction site. Light impinging onto the inner surface from within the luminescent converter component may then directly pass through this surface into the solar cell, where it can be converted into electrical energy.

According to another embodiment, the LSC system comprises as an additional component an optical system for guiding light extracted from the luminescent converter component to the above mentioned solar cell. To this end, the optical system will usually be arranged in the space between the luminescent converter component and the solar cell. The optical system allows to arrange the solar cell more independently from the extraction sites at the inner surface of the converter component. The optical system may in particular realize some concentrating function, collecting light at a first area of extraction sites and delivering this light at a second, smaller area of the solar cell. This allows to further decrease the size of the (expensive) solar cell area and thus to decrease the overall cost of the LSC system. It becomes particularly possible to use a single (or a few) solar cell(s) for the conversion of light extracted from a plurality of extraction sites.

The aforementioned optical system may optionally comprise at least one collimator for redirecting light extracted at an extraction site such that it is substantially in alignment with a given desired direction. The collimator may for example be a transparent body that redirects light by refraction, or it may comprise reflective surfaces for redirecting.

The optical system may further comprise at least one lens for focusing the extracted light onto the solar cell. Such a lens may favorably be combined with one or more of the aforementioned collimators, which align the extracted diffuse light with a main direction such that it can be deflected towards a desired destination by the lens.

In many applications, the luminescent converter component will simply have a planar, substantially plate-like shape. The invention comprises however also embodiments in which the luminescent converter component has a curved three-dimensional shape, for example a bell shape or a cylindrical shape. As an example, the curvature may be such that light extracted at the extraction sites is focused to a common region, where for instance a solar cell may be located.

BRIEF DESCRIPTION OF THE DRAWINGS

These and other aspects of the invention will be apparent from and elucidated with reference to the embodiment(s) described hereinafter. These embodiments will be described by way of example with the help of the accompanying drawings in which:

> Figure 1 schematically shows a section through a first LSC system according to the present invention having slanted mirroring surfaces as light extraction components;
> Figure 2 shows a perspective view of an LSC system like that of Figure 1 having the design of a one-dimensional array;
> Figure 3 shows a perspective view of an LSC system like that of Figure 1 having the design of a two-dimensional array, wherein the luminescent converter component has been partially removed to show the underlying solar cell grid;
> Figure 4 schematically shows a section through an LSC system comprising an optical system with collimators receiving the light extracted by slanted mirroring surfaces as light extraction components;
> Figure 5 schematically shows a section through an LSC system comprising a plurality of micro-collimators that are in optical contact to a uniform converter component at extraction sites;
> Figure 6 schematically shows a section through an LSC system like that of Figure 5 having a curved three-dimensional shape of the luminescent converter component;
> Figure 7 schematically illustrates a spherical three-dimensional design of the LSC system;
> Figure 8 schematically illustrates a cylindrical three-dimensional design of the LSC system.

Like reference numbers or numbers differing by integer multiples of 100 refer in the Figures to identical or similar components.

DESCRIPTION OF PREFERRED EMBODIMENTS

A Luminescent Solar Concentrator (LSC) essentially comprises a flat glass or plastic sheet containing or coated with luminophores (dyes or phosphors) that absorb sunlight and emit light at longer wavelengths. A fraction of the longer-wavelength light is trapped by total internal reflection (TIR) and guided to the edges of the LSC sheet where it is coupled into small-area, efficient solar cells. To prevent escape of the light that is not captured by TIR, a wavelength-selective mirror (also called photonic band-stop filter, interference filter or Bragg mirror) consisting of a multilayer of dielectric layers or cholesteric liquid-crystal-based materials can be applied on top of the LSC sheet (cf. DE 2 737 847 A1; WO 2006/088369 A2; Peters et al., SPIE 7002 (2008) 70020V).

An advantage of the LSC is that it captures direct as well as diffuse sunlight without the need for accurate solar tracking. But of course most light is captured when the surface is oriented perpendicular to the direct sunlight.

While being confined by TIR, the long-wavelength radiation experiences losses in the lightguide of an LSC due to scattering and re-absorption. This causes the efficiency of the system to drop when the total length and width of the lightguide exceeds about 5-10 times its thickness, depending on many geometrical and material parameters. Efficiency can be increased by increasing the thickness of the lightguide, but this increases the weight and materials cost considerably. Hence there is a need for an enhanced efficiency LSC without these drawbacks.

The aforementioned problems are addressed by an embodiment of the present invention which comprises a modular approach enabled by the use of micro-optical elements. Instead of a thin single LSC lightguide with a non-optimum length over thickness ratio, an array of miniaturized light guides is used that each have an optimum length over thickness ratio. The efficiency of the single LSC light guide is therewith greatly enhanced.

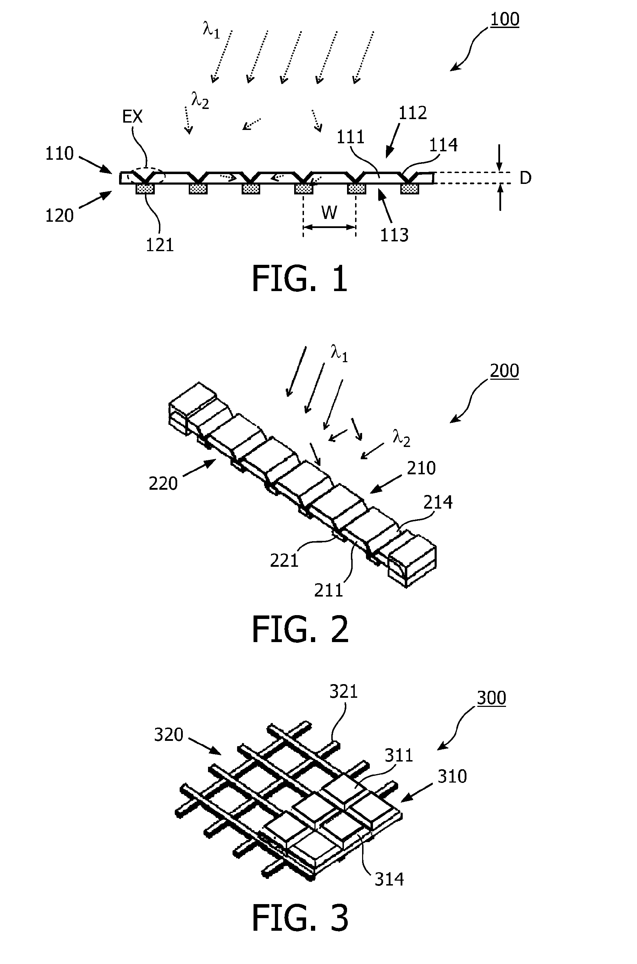

A first embodiment of the proposed solution is illustrated in the sectional view through an LSC system 100 of Figure 1. The LSC system 100 comprises (instead of a uniform, flat sheet) a plurality of luminescent converter modules 111 of thickness D that commonly constitute a "luminescent converter component" 110. Micro-optical facets and wavelength selective mirror coatings are provided at the slanted edges of each luminescent converter module 111, constituting mirroring surfaces 114 as light extraction components which extract light from the luminescent converter component 110. These light extraction components are arranged at extraction sites EX spaced a mean distance W apart from each other. Furthermore, an array 120 of high efficiency solar cell 121 is provided such that a solar cells 121 is arranged at each extraction site EX.

When direct external (sun-) light $\lambda_1$ and/or dif-

fuse light $\lambda_2$ impinges onto the LSC system, it can enter the luminescent converter modules 111 through their outer surfaces 112. Light impinging on the wavelength-selective mirroring surfaces 114 may pass these and either enter the modules 111 or directly reach the solar cells 121. Once within the luminescent converter component 110, the external light will (at least partially) be absorbed by the luminescent material therein according to an absorption coefficient $a_x$ that is characteristic of the converter's material. For (infinitesimally) small distances $\Delta z$, the drop $\Delta I$ of the incident sunlight intensity is approximately proportional to the intensity I, with the absorption coefficient $a_x$ as proportionality constant, i.e. $\Delta I = -a_x \cdot I \cdot \Delta z$. For larger distances z, this yields the exponential law

$$I(z) = I_0 \cdot \exp(-a_x \cdot z)$$

with some given intensity $I_0$ at z = 0.

The absorbed (sun-)light is reemitted at longer wavelengths. The reabsorption and/or scattering of this reemitted luminescence light by the material of the converter component can similarly be characterized by a reabsorption coefficient $a_c$. For a high conversion efficiency, the ratio

$$R = a_x/a_c$$

should be as large as possible, for example R = 10000 for a good material. One example of a material for the converter component is Lumogen® F Red 305 from company BASF which has coefficients of about $a_x$ = 10 ppm$^{-1}$m$^{-1}$ and $a_c$ = 0.1 ppm$^{-1}$m$^{-1}$ and hence a ratio of about R = 100. Further examples of suitable luminescent materials that can be used in the converter component can be found in the literature (e.g. WO 2009/067479 A2.)

It should be noted that the above coefficients $a_x$, $a_c$ are defined with respect to the whole converter component's material, not only with respect to the luminescent material thereof. This makes a difference if the converter component does not completely consist of the luminescent material, but comprises for instance some matrix material like a transparent polymer (e.g. a polycarbonate or acrylic ester polymer, cf. WO 2009/067479 A2).

The converted light as well as direct light propagates by TIR substantially towards the edges of the luminescent converter modules 111, i.e. to the extraction sites EX. Here the light is deflected by the mirroring surfaces 114 and leaves the luminescent converter component 110 through its "inner surface" 113, entering a solar cell 121 where it is converted into electrical energy.

The distances W between neighboring extraction sites EX are chosen such that they are less than (or equal to) about (0.1R)- times the thickness D of the luminescent converter component 110, i.e. $W \leq 0.1 \cdot RD$.

This guarantees that a high efficiency can be achieved while the converter component 110 does not become too heavy or expensive. Assuming for example that 99% of the incident sunlight should be absorbed, and considering the losses that occur in the transport of the converted light towards the solar cells at the edges, one may require that this transport has to have a yield of for instance > 90%. It can then be deduced that the geometrical ratio W/D should be chosen as W/D < 0.043·R. If a transport yield of > 95% is required instead of > 90%, then W/D < 0.022·R should hold. As presently used materials have a ratio R of about 100 (due to relatively large reabsorption losses), the latter requirement amounts to W/D < 2.

While the luminescent converter modules 111 are drawn having parallel outer and inner surfaces 112 and 113, they can have different shapes, too, e.g. like wedges or tapers.

A complete LSC system having a sectional view like that of Figure 1 may for example be a one-dimensional stripe array like the LSC system 200 of Figure 2, or it may be a two-dimensional grid array like the LSC system 300 illustrated in Figure 3. In this way, the solar cell array 210 or 310, respectively, can be manufactured on a thin flat substrate.

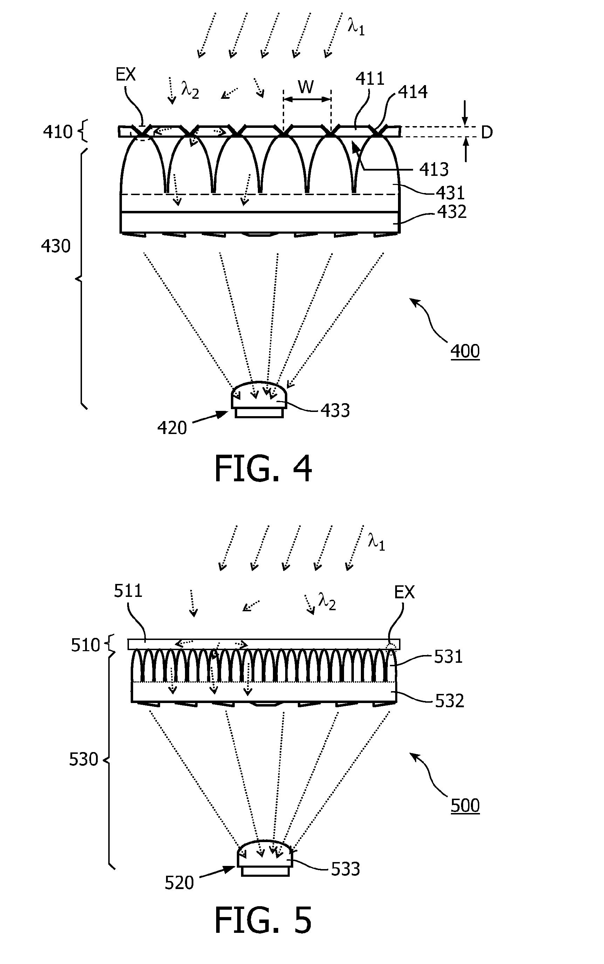

Figures 4 to 7 illustrate alternative embodiments of LSC systems in which the array of solar cells is replaced by a single high efficiency solar cell.

In the LSC system 400 shown in a sectional view in Figure 4, the luminescent converter component 410 is analogous to that of Figure 1, i.e. having mirroring surfaces 414 at extraction sites EX as light extracting components. Now there is however an additional optical system 430 between the inner surface 413 of the luminescent converter component 410 and a (single) photo cell 420. The optical system 430 comprises an array of micro-concentrators or -collimators 431 that are positioned at the extraction sites EX. Behind the collimators 431 the light has strong directionality. Using an additional thin Fresnel or diffractive lens 432, all the light can be focused on the single solar cell 420. Optionally this is provided with collection optics like a half sphere 433 as shown, or a Compound Parabolic Concentrator (CPC, not shown).

The advantage compared to a classical single CPC system that tracks the sun is that the proposed system captures diffuse sunlight much better.

Figure 5 shows yet another embodiment of an LSC system 500. Here the luminescent converter component 510 is a uniform, flat sheet 511. The extraction sites EX are constituted by micro-collimators 531 of the optical system 530, which extract the light by being in close optical contact with the lightguide 511. Again a thin flat lens 532 focuses all radiation onto a single solar cell 520.

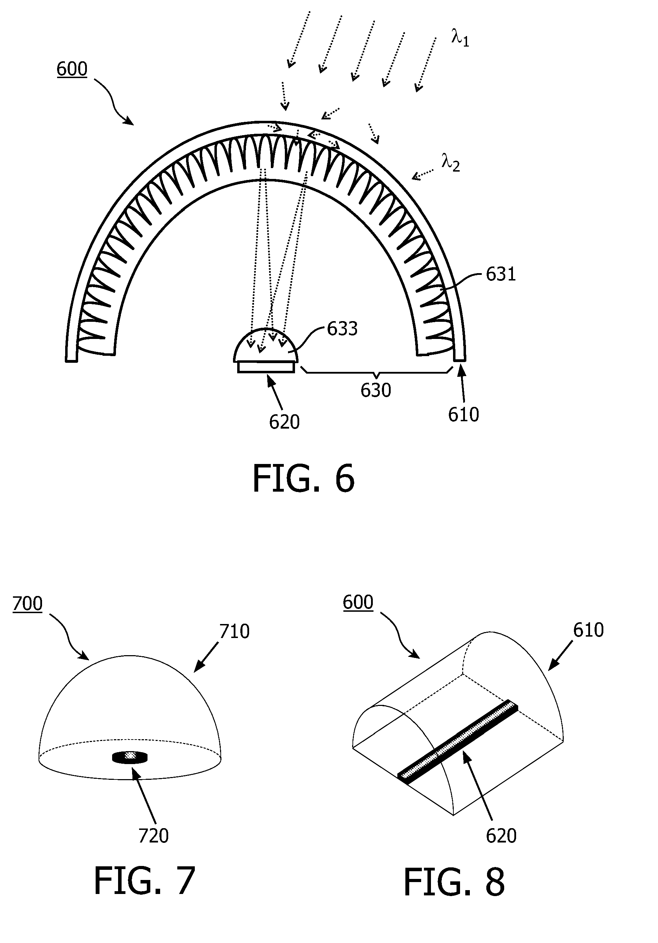

Figure 6 shows an LSC system 600 in which the thin lens (432 and 532 of the above designs) is eliminated by providing the luminescent converter component 610 and the associated collimators 631 with a curved three-dimensional shape. This 3D shape can be a dome, as further illustrated in Figure 7, or a cylinder as illustrated in Figure 8. An advantage of this embodiment is that no solar tracking is necessary, and the efficiency for direct sunlight is enhanced.

In summary, preferred embodiments of the present invention have been described in detail that relate to a Luminescent Solar Concentrator system comprising the following features/components:

- one or more light guides doped and/or coated with luminophores;
- micro-optical extraction and/or concentrator features;
- optionally one or more solar cells;
- optionally a 1D stripe of solar cells;
- optionally a 2D grid of solar cells;
- optionally an array of micro-concentrators, e.g. CPCs;
- optionally a thin lens, e.g. Fresnel or diffractive optics;
- optionally a 3D-shaped light guide, e.g. cylindrical or spherical.

Finally it is pointed out that in the present application the term "comprising" does not exclude other elements or steps, that "a" or "an" does not exclude a plurality, and that a single processor or other unit may fulfill the functions of several means. The invention resides in each and every novel characteristic feature and each and every combination of characteristic features. Moreover, reference signs in the claims shall not be construed as limiting their scope.

**Claims**

1. A Luminescent Solar Concentrator system (100-700), comprising:

   a) a luminescent converter component (110-710) having a thickness D between an outer surface (112) and inner surface (113) and a ratio R between the absorption coefficient ($a_x$) for sunlight and the reabsorption coefficient ($a_c$) for luminescence light;
   b) a plurality of light extraction components (114-414, 531, 631) for extracting light from the luminescent converter component through its inner surface (113), **characterized in that** said plurality of light extraction components are located at extraction sites (EX) having non-zero distances $W \leq 0.1 \cdot R \cdot D$ from each other.

2. A method for collecting and concentrating external light, particularly sunlight, comprising the following steps:

   a) collecting external light ($\lambda_1$, $\lambda_2$) by a luminescent converter component (110-710) having a thickness D between an outer surface (112) and an inner surface (113) and a ratio R between the absorption coefficient ($a_x$) for sunlight and the reabsorption coefficient ($a_c$) for luminescence light;
   b) extracting light from the luminescent converter component through its inner surface at extraction sites (EX)
   **characterized in that** said extraction sites (EX) have non-zero distances $W \leq 0.1 \cdot R \cdot D$ from each other.

3. The Luminescent Solar Concentrator system (100-700) according to claim 1 or the method according to claim 2,
   **characterized in that** the distances W between the light extraction sites (EX) range between about $0.02 \cdot R \cdot D$ and about $0.05 \cdot R \cdot D$.

4. The Luminescent Solar Concentrator system (100-700) according to claim 1,
   **characterized in that** the thickness D of the luminescent converter component (110-710) ranges between about 3000 $\mu$m and 100 $\mu$m.

5. The Luminescent Solar Concentrator system (100-400) according to claim 1 or the method according to claim 2,
   **characterized in that** at least one light extraction component comprises a mirroring surface (114-414) of the luminescent converter component (110-410).

6. The Luminescent Solar Concentrator system (100-400) according to claim 5,
   **characterized in that** the mirroring surface (114-414) is slanted with respect to the inner surface (113).

7. The Luminescent Solar Concentrator system (100-400) according to claim 5,
   **characterized in that** the mirroring surface (114-414) has a wavelength-selective reflectivity.

8. The Luminescent Solar Concentrator system (500-600) according to claim 1,
   **characterized in that** at least one light extraction component comprises a transparent optical element (531, 631) contacting the inner surface of the luminescent converter component (510, 610).

9. The Luminescent Solar Concentrator system (100-700) according to claim 1 or the method according to claim 2,
   **characterized in that** there is at least one solar cell (120-720) that receives extracted light.

**10.** The Luminescent Solar Concentrator system (100-300) or the method according to claim 9, **characterized in that** the solar cell (120-320) is located at an extraction site (EX).

**11.** The Luminescent Solar Concentrator system (400-700) or the method according to claim 9, **characterized in that** it comprises an optical system (430-630) for guiding extracted light to the solar cell (420-720).

**12.** The Luminescent Solar Concentrator system (400-700) or the method according to claim 11, **characterized in that** the optical system (430-630) comprises at least one collimator (431-631) for redirecting light extracted at an extraction site (EX) such that it is substantially in alignment with a given direction.

**13.** The Luminescent Solar Concentrator system (400, 500) or the method according to claim 11, **characterized in that** the optical system (430, 530) comprises at least one lens (432, 532) for focusing extracted light onto the solar cell (420, 520).

**14.** The Luminescent Solar Concentrator system (600, 700) according to claim 1 or the method according to claim 2, **characterized in that** the luminescent converter component (610, 710) has a curved three-dimensional shape.

**Patentansprüche**

**1.** System (100-700) mit lumineszierendem Solarkonzentrator, umfassend:

a) eine lumineszierende Konverterkomponente (110-710) mit einer Dicke D zwischen einer Außenfläche (112) und einer Innenfläche (113) sowie einem Verhältnis R zwischen dem Absorptionskoeffizienten ($a_x$) für Sonnenlicht und dem Reabsorptionskoeffizienten ($a_c$) für Lumineszenzlicht;
b) mehrere Lichtextraktionskomponenten (114-414, 531, 631), um Licht aus der lumineszierenden Konverterkomponente durch ihre Innenfläche (113) zu extrahieren, **dadurch gekennzeichnet, dass** die mehreren Lichtextraktionskomponenten an Extraktionsstellen (EX) mit nicht-null-Abständen W ≤ 0,1-R-D voneinander positioniert sind.

**2.** Verfahren zum Auffangen und Konzentrieren von externem Licht, insbesondere Sonnenlicht, das die folgenden Schritte umfasst, wonach:

a) externes Licht ($\lambda_1$, $\lambda_2$) von einer lumineszierenden Konverterkomponente (110-710) mit einer Dicke D zwischen einer Außenfläche (112) und einer Innenfläche (113) sowie einem Verhältnis R zwischen dem Absorptionskoeffizienten ($a_x$) für Sonnenlicht und dem Reabsorptionskoeffizienten ($a_c$) für Lumineszenzlicht aufgefangen wird;
b) Licht aus der lumineszierenden Konverterkomponente durch ihre Innenfläche an Extraktionsstellen (EX) extrahiert wird, **dadurch gekennzeichnet, dass** die Extraktionsstellen (EX) nicht-null-Abstände W ≤ 0,1-R-D voneinander aufweisen.

**3.** System (100-700) mit lumineszierendem Solarkonzentrator nach Anspruch 1 oder Verfahren nach Anspruch 2, dadurch gekenntzeichnet, dass die Abstände W zwischen den Lichtextraktionsstellen (EX) im Bereich zwischen etwa 0,02-R-D und etwa 0,05-R-D liegen.

**4.** System (100-700) mit lumineszierendem Solarkonzentrator nach Anspruch 1, dadurch gekenntzeichnet, dass die Dicke D der lumineszierenden Konverterkomponente (110-710) im Bereich zwischen etwa 3000 $\mu$m und 100 $\mu$m liegt.

**5.** System (100-400) mit lumineszierendem Solarkonzentrator nach Anspruch 1 oder Verfahren nach Anspruch 2, **dadurch gekennzeichnet, dass** mindestens eine Lichtextraktionskomponente eine spiegelnde Oberfläche (114-414) der lumineszierenden Konverterkomponente (110-410) umfasst.

**6.** System (100-400) mit lumineszierendem Solarkonzentrator nach Anspruch 5, **dadurch gekennzeichnet, dass** die spiegelnde Oberfläche (114-414) gegenüber der Innenfläche (113) geneigt ist.

**7.** System (100-400) mit lumineszierendem Solarkonzentrator nach Anspruch 5, **dadurch gekennzeichnet, dass** die spiegelnde Oberfläche (114-414) eine wellenlängenselektive Reflektivität aufweist.

**8.** System (500-600) mit lumineszierendem Solarkonzentrator nach Anspruch 1, **dadurch gekennzeichnet, dass** mindestens eine Lichtextraktionskomponente ein die Innenfläche der lumineszierenden Konverterkomponente (510, 610) kontaktierendes, transparentes optisches Element (531, 631) umfasst.

**9.** System (100-700) mit lumineszierendem Solarkonzentrator nach Anspruch 1 oder Verfahren nach Anspruch 2,

**dadurch gekennzeichnet, dass** mindestens eine Solarzelle (120-720) vorhanden ist, die extrahiertes Licht empfängt.

10. System (100-300) mit lumineszierendem Solarkonzentrator oder Verfahren nach Anspruch 9,
**dadurch gekennzeichnet, dass** sich die Solarzelle (120-320) an einer Extraktionsstelle (EX) befindet.

11. System (400-700) mit lumineszierendem Solarkonzentrator oder Verfahren nach Anspruch 9,
**dadurch gekennzeichnet, dass** es ein optisches System (430-630) umfasst, um extrahiertes Licht zu der Solarzelle (420-720) zu leiten.

12. System (400-700) mit lumineszierendem Solarkonzentrator oder Verfahren nach Anspruch 11,
**dadurch gekennzeichnet, dass** das optische System (430-630) mindestens einen Kollimator (431-631) umfasst, um an einer Extraktionsstelle (EX) extrahiertes Licht so zurückzuleiten, dass es sich in einer Flucht mit einer vorgegebenen Richtung befindet.

13. System (400, 500) mit lumineszierendem Solarkonzentrator oder Verfahren nach Anspruch 11,
**dadurch gekennzeichnet, dass** das optische System (430, 530) mindestens eine Linse (432, 532) umfasst, um extrahiertres Licht auf die Solarzelle (420, 520) zu fokussieren.

14. System (600, 700) mit lumineszierendem Solarkonzentrator nach Anspruch 1 oder Verfahren nach Anspruch 2,
**dadurch gekennzeichnet, dass** die lumineszierende Konverterkomponente (610, 710) eine gebogene dreidimensionale Form aufweist.

**Revendications**

1. Système concentrateur solaire luminescent (100-700), comprenant :

a) un composant convertisseur luminescent (110-710) possédant une épaisseur D entre une surface extérieure (112) et une surface intérieure (113) et un rapport R entre le coefficient d'absorption $(a_x)$ pour de la lumière solaire et le coefficient de réabsorption $(a_c)$ pour de la lumière de luminescence ;
b) une pluralité de composants d'extraction de lumière (114-414, 531, 631) pour extraire de la lumière à partir du composant convertisseur luminescent à travers sa surface intérieure (113),
**caractérisé en ce que** ladite pluralité de composants d'extraction de lumière sont situés à des sites d'extraction (EX) possédant des distances non nulles W$\leq$ 0,1 R D les uns des autres.

2. Procédé pour collecter et concentrer de la lumière externe, particulièrement de la lumière solaire, comprenant les étapes suivantes :

a) la collecte de lumière externe $(\lambda_1, \lambda_2)$ par un composant convertisseur luminescent (110-710) possédant une épaisseur D entre une surface extérieure (112) et une surface intérieure (113) et un rapport R entre le coefficient d'absorption $(a_x)$ pour de la lumière solaire et le coefficient de réabsorption $(a_c)$ pour de la lumière de luminescence ;
b) l'extraction de lumière à partir du composant convertisseur luminescent à travers sa surface intérieure à des sites d'extraction (EX),
**caractérisé en ce que** lesdits sites d'extraction (EX) possèdent des distances non nulles W$\leq$ 0,1 R D les uns des autres.

3. Système concentrateur solaire luminescent (100-700) selon la revendication 1 ou procédé selon la revendication 2,
**caractérisé en ce que** les distances W entre les sites d'extraction de lumière (EX) varient entre environ 0,02 R D et environ 0,05 R D.

4. Système concentrateur solaire luminescent (100-700) selon la revendication 1,
**caractérisé en ce que** l'épaisseur D du composant convertisseur luminescent (110-710) varie entre environ 3000 $\mu$m et 100 $\mu$m.

5. Système concentrateur solaire luminescent (100-400) selon la revendication 1 ou procédé selon la revendication 2,
**caractérisé en ce qu'**au moins un composant d'extraction de lumière comprend une surface de réflexion (114-414) du composant convertisseur luminescent (110-410).

6. Système concentrateur solaire luminescent (100-400) selon la revendication 5, **caractérisé en ce que** la surface de réflexion (114-414) est inclinée par rapport à la surface intérieure (113).

7. Système concentrateur solaire luminescent (100-400) selon la revendication 5, **caractérisé en ce que** la surface de réflexion (114-414) possède une réflectivité sélective de longueur d'onde.

8. Système concentrateur solaire luminescent (500-600) selon la revendication 1, **caractérisé en ce qu'**au moins un composant d'extraction de lumière comprend un élément optique transparent (531, 631) entrant en contact avec la surface intérieure du composant convertisseur luminescent (510, 610).

9. Système concentrateur solaire luminescent (100-700) selon la revendication 1 ou procédé selon la revendication 2,
**caractérisé en ce qu'**il y a au moins une cellule solaire (120-720) qui reçoit de la lumière extraite.

10. Système concentrateur solaire luminescent (100-300) ou procédé selon la revendication 9, **caractérisé en ce que** la cellule solaire (120-320) est située à un site d'extraction (EX).

11. Système concentrateur solaire luminescent (400-700) ou procédé selon la revendication 9, **caractérisé en ce qu'**il comprend un système optique (430-630) pour guider de la lumière extraite vers la cellule solaire (420-720).

12. Système concentrateur solaire luminescent (400-700) ou procédé selon la revendication 11, **caractérisé en ce que** le système optique (430-630) comprend au moins un collimateur (431-631) pour rediriger de la lumière extraite à un site d'extraction (EX) de sorte qu'elle soit sensiblement en alignement avec une direction donnée.

13. Système concentrateur solaire luminescent (400, 500) ou procédé selon la revendication 11, **caractérisé en ce que** le système optique (430, 530) comprend au moins une lentille (432, 532) pour focaliser de la lumière extraite sur la cellule solaire (420, 520).

14. Système concentrateur solaire luminescent (600, 700) selon la revendication 1 ou procédé selon la revendication 2,
**caractérisé en ce que** le composant convertisseur luminescent (610, 710) présente une forme tridimensionnelle incurvée.

FIG. 1

FIG. 2

FIG. 3

FIG. 4

FIG. 5

600

$\lambda_1$

$\lambda_2$

631

633

630

620

610

# FIG. 6

700

710

720

# FIG. 7

600

610

620

# FIG. 8

**EP 2 577 743 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009067479 A2
- US 20090126778 A1
- US 4110123 A
- DE 2737847 A1
- WO 2006088369 A2

**Non-patent literature cited in the description**

- **PETERS et al.** *SPIE 7002,* 2008, 70020V